# EUROPÄISCHE PATENTSCHRIFT

(11) **EP 1 264 330 B1**
(45) Veröffentlichungstag und Bekanntmachung des Hinweises auf die Patenterteilung: **16.07.2003**
(21) Anmeldenummer: 01921330.5
(22) Anmeldetag: 13.03.2001
(51) Int. Cl.: H01J 37/32

(54) **VERFAHREN UND VORRICHTUNG ZUR PLASMAGESTÜTZTEN OBERFLÄCHENBEHANDLUNG UND VERWENDUNG DES VERFAHRENS**
METHOD AND DEVICE FOR THE PLASMA-ACTIVATED SURFACE TREATMENT AND USE OF THE INVENTIVE METHOD
PROCEDE ET DISPOSITIF DE TRAITEMENT DE SURFACE ACTIVE PAR PLASMA ET UTILISATION DUDIT PROCEDE

(30) Priorität: 14.03.2000 DE 10012307; 15.11.2000 DE 10056564
(43) Veröffentlichungstag der Anmeldung: 11.12.2002
(73) Patentinhaber: FRAUNHOFER-GESELLSCHAFT ZUR FÖRDERUNG DER ANGEWANDTEN FORSCHUNG E.V., 80636 München (DE)
(72) Erfinder: KLAGES, Claus-Peter, 38102 Braunschweig (DE); THYEN, Rudolf, 21033 Hamburg (DE); EICHLER, Marko, 38106 Braunschweig (DE); LINDMAYER, Manfred, 38104 Braunschweig (DE)
(86) Internationale Anmeldenummer: EP0102815
(87) Internationale Veröffentlichungsnummer: WO01069644

(56) Entgegenhaltungen:
- EP-A- 0 881 865
- WO-A-01/27969
- DE-A- 19 826 418
- US-A- 6 147 452

## Beschreibung

Die Erfindung betrifft ein Verfahren und eine Vorrichtung zur plasmagestützten Behandlung von vorgebbaren Bereichen der Oberfläche eines Körpers gemäß Patentansprüchen 1 bzw. 7, und die Verwendung des Verfahrens gemäß Patentansprüchen 13 und 14. Mit dem erfindungsgemäßen Verfahren kann mittels einer Gasentladung die Oberfläche eines Materials in vorgebbaren Bereichen modifiziert werden.

Bei den zu behandelnden Materialien kann es sich um elektrische Isolatoren wie zum Beispiel Polymere, oder aber um Metalle handeln. Insbesondere dielektrische Materialien können mit dem erfindungsgemäßen Verfahren behandelt werden.

Die Modifikation kann in einer Aktivierung der Oberfläche bestehen, und dabei insbesondere in einer Aktivierung mittels eines Ätzprozesses. Weiterhin kann die Modifikation in einer Oxidation eines Metalls, oder einer Abtragung von Oberflächenmaterial bestehen. Unter einer Modifikation soll nachfolgend auch die Änderung der chemischen Struktur der Oberfläche verstanden werden, so zum Beispiel das Aufbringen bestimmter funktioneller Gruppen bei Polymeren wie zum Beispiel Polytetrafluorethylen (PTFE). Die Modifikation kann auch in einer Schichtabscheidung bestehen, in der Änderung physikalischer Größen der Oberfläche (wie zum Beispiel der Oberflächenleitfähigkeit oder der Oberflächenspannung) oder in anderen Modifikationen bestehen.

### Stand der Technik

Für eine große Zahl technischer Anwendungen ist es erforderlich, nur auf bestimmten Flächenelementen der Oberfläche eines Materials Modifikationen vorzunehmen.

Wenn nur bestimmte, vorgebbare Bereiche der Oberfläche modifiziert werden sollen, werden meist photolithographische Subtraktivverfahren angewandt:

Bei einem bekannten Subtraktivverfahren wird die Oberfläche ganzflächig modifiziert, und anschließend die Modifizierung wieder an definierten Stellen beseitigt. Soll zum Beispiel ein Polymer ortsselektiv metallisiert werden, so kann dies dadurch realisiert werden, dass zunächst ein Metall vollflächig auf ein Polymer aufgesputtert wird, und dann die Metallschicht photolithographisch strukturiert wird.

Die Strukturierung erfolgt dadurch, dass die Oberfläche vollflächig mit einem Fotolack abgedeckt wird, die Oberfläche mittels einer Maske mit geeigneter Struktur belichtet wird, und der Fotolack entwickelt wird. Je nachdem, ob es sich um einen positiv oder negativ arbeitenden Fotolack handelt, wird der Fotolack anschließend an den belichteten oder unbelichteten Stellen entfernt.

Es folgt ein Ätzprozess, bei dem das freigelegte Metall entfernt wird (z.B. nasschemisch oder durch Sputterätzen). In einem letzten Verfahrensschritt wird der restliche Fotolack entfernt (zum Beispiel durch Auflösen oder Veraschen) und die darunter befindlichen metallischen Bereiche freigelegt.

Bei einem weiteren bekannten photolithographischen Subtraktiwerfahren wird die Oberfläche zunächst mit einem Fotolack versehen, dieser belichtet, entwickelt und partiell abgetragen. Anschließend wird das Metall aufgebracht und der Fotolack in einem sog. Lift-Off-Prozess entfernt. Das Metall verbleibt nur an denjenigen Stellen der Oberfläche, die nicht mit dem Fotolack bedeckt waren.

Weiterhin gibt es Subtraktivverfahren, bei denen eine direkte Strukturierung mittels Laserstrahlung erfolgt, d.h. die Belichtungsmaske wird durch einen schreibenden Laserstrahl ersetzt. Der Laserstrahl beaufschlagt dann nur die vorgegebenen Bereiche der Oberfläche.

Material- und kostenschonender ist eine Behandlung , bei der die Behandlungseffekte von Anfang an nur in den vorgegebenen Oberflächenbereichen, d.h. nur lokal, stattfinden. Ein derartiges Additiwerfahren unter Einsatz elektromagnetischer Strahlung lehrt zum Beispiel die EP 0 92 262 A1 für den Bereich der Metallisierung von Polymeren.

Alternativ zur Modifikation von Oberflächen mittels elektromagnetischer Strahlung können die Oberflächen auch einer Plasmabehandlung unterworfen werden. Der besondere Wert einer auf einer Gasentladung bzw. einem plasmagestützten Verfahren liegenden Behandlung liegt darin, dass die Gasentladung sehr aktive Teilchen in Form von hochenergetischen Elektronen, Ionen, Photonen, Atomen, Radikalen etc. enthält, die es erlauben, bei recht niedrigen Temperaturen auch relativ reaktionsträge Materialien zu modifizieren. Derartige Materialien können elektrische Isolatoren sein, z.B. ein Polymer, ein Glas, oder eine Keramik. So kann die Modifikation einer Polymeroberfläche darin bestehen, dass dieses anoxidiert und damit benetzbar gemacht wird, dass die Polymere oxidativ oder mittels Ionenbeschuss abgetragen werden, dass Metalle oxidiert oder gesputtert werden etc.

Für die Beschichtung von Isolatoroberflächen wurde eine Oberflächenentladung bereits in (Bugaev et al., Surf. Coat. Technol. 96, S. 123 ff, 1997) beschrieben. In diesem Artikel wird eine Entladung gewählt, die zwischen zwei Elektroden brennt welche sich auf unterschiedlichem Potential befinden. Die Potentialdifferenz beträgt 18 kV. Der Entladungskanal schließt beide Elektroden kurz sodass ein galvanischer Strom fließt.

Um nur vorbestimmte Bereiche der Oberfläche mit dem Plasma behandeln zu können, werden bei Plasmabehandlungsverfahren mitunter mechanische Maskierungen eingesetzt. Durch die mechanischen Maskierungen wird verhindert, dass vorgegebene Oberflächenbereiche dem Plasma ausgesetzt werden.

Wie bei den mit elektromagnetischer Strahlung arbeitenden Verfahren ist es jedoch auch hier wünschenswert, dass die Plasmabehandlung ohne mechanische Maskierungen auskommt, und die Behandlung mittels eines Additiwerfahrens nur in den vorgegebenen Oberflächenbereichen erfolgt.

Die DE 198 26 418 A1 beschreibt ein Verfahren zur Erzeugung eines Plasmas, bei dem die Elektroden in einzelne Einheiten unterteilt sind. In jeder Einheit wird derart ein Mikroplasma gezündet, dass das aus den Einzelplasmen gebildete Gesamtplasma eine besonders große Fläche bzw. ein besonders großes Volumen aufweist.

### Darstellung der Erfindung

Der Erfindung liegt das technische Problem zugrunde, die Nachteile nach dem Stand der Technik weitestgehend zu vermeiden. Insbesondere soll ein plasmagestütztes Additivverfahren und eine hierfür geeignete Vorrichtung zur plasmagestützten Oberflächenbehandlung bereitgestellt werden, bei dem vorgebbare Bereiche der Oberfläche eines Materials behandelt werden können, ohne dass der Einsatz mechanischer Maskierungen erforderlich ist.

Die Lösung dieses technischen Problems wird durch die Merkmale des Anspruchs 1 und 7 gelöst. Vorteilhafte Weiterbildungen sind in den Unteransprüchen angegeben.

Erfindungsgemäß wurde erkannt, dass sich das zugrundeliegende technische Problem für ein Verfahren zur plasmagestützten Behandlung von vorgebbaren Bereichen der Oberflächen eines Materials dadurch lösen lässt, dass ein elektrischer Isolator derart zwischen zwei Elektroden eingebracht wird, dass in den vorgegebenen Oberflächenbereichen kein formschlüssiger Kontakt zwischen dem Isolator und der jeweiligen Elektrode vorliegt, und dass in den restlichen Oberflächenbereichen der Isolator und die jeweilige Elektrode in formschlüssigem Kontakt stehen, so dass sich beim Anlegen einer Spannung an die Elektroden bei Gasdrücken zwischen 10⁴ Pascal und 10⁶ Pascal eine kalte, transiente Gasentladung ausschließlich in den vorgegebenen Oberflächenbereichen ausbildet.

Mit dem erfindungsgemäßen Verfahren kann der zu behandelnde Körper der Isolator, eine oder beide Elektroden, oder Isolator und der oder die Elektroden sein. Nachfolgend soll die Erfindung für den Fall einer Oberflächenbehandlung des elektrischen Isolators näher beschrieben werden.

Im Sinne der vorliegenden Erfindung erfolgt die Auswahl derjenigen Oberflächenbereiche des elektrischen Isolators, bevorzugt eines Dielektrikums, welche einer Plasmabehandlung unterzogen werden, dadurch, dass in den zu behandelnden Oberflächenbereichen kein formschlüssiger Kontakt zur angrenzenden Elektrode gegeben ist, und in den nicht zu behandelnden Oberflächenbereichen Formschluss vorliegt.

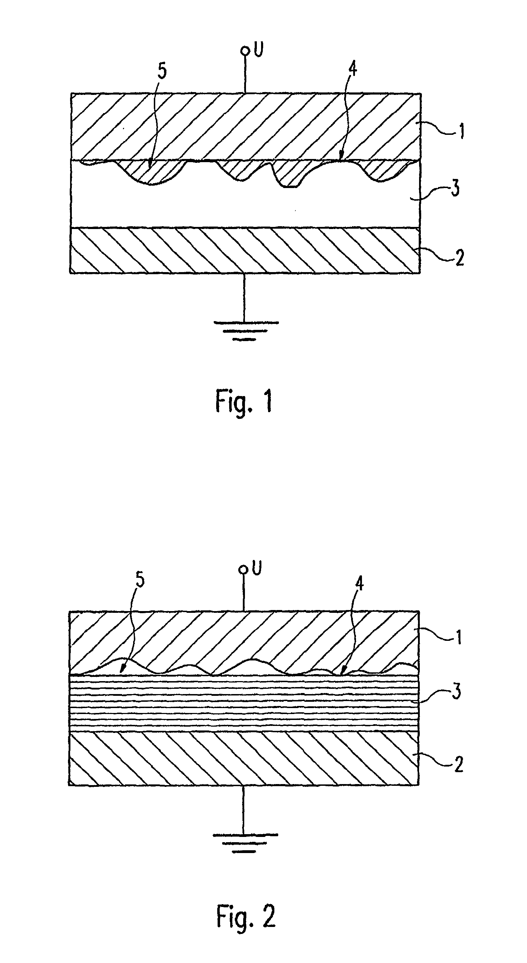

Im einfachsten geometrischen Fall sind die Elektroden und das Dielektrikum planare Körper. Dies illustrieren **Fig. 1** und **Fig. 2.** In **Fig. 1** weist das sich zwischen den beiden Elektroden 1, 2 befindliche Dielektrikum 3 Bereiche 4 auf, in welchen es formschlüssig mit der angrenzenden Elektrode Kontakt hat. Dort findet keine Gasentladung statt. In den Bereichen 5 ohne formschlüssigem Kontakt kommt es zur Ausbildung eines Hohlraumes. In diesem Hohlraum, welcher gasgefüllt ist, kommt es bei Anlegen einer Spannung U zur Ausbildung einer Hohlraumteilentladung. Das Plasma dieser Gasentladung wechselwirkt mit der Oberfläche des Dielektrikums und modifiziert wie gewünscht dessen Oberfläche in diesem Oberflächenbereich.

Spiegelbildlich zur obigen Vorgehensweise kann auch die metallische Elektrode derartige Vertiefungen aufweisen. **Fig. 2** zeigt demgemäß zwei Elektroden 1, 2 mit einem plattenförmigen Dielektrikum 3, wobei die Elektrode 1 Rezesse 5 aufweist in denen es zur Ausbildung der Gasentladung kommt. Selbstverstandlich ist es auch möglich, dass Elektrode und Dielektrikum Vertiefungen aufweisen.

Unter einem Hohlraum soll vorliegend auch ein Raum verstanden werden, der zumindest teilweise von Material umgeben ist welches netzartig oder porös ausgeführt ist, sodass ein Gasaustausch mit der Umgebung möglich ist.

Vorteilhafterweise weisen die gebildeten Hohlräume in Richtung des von außen angelegten elektrischen Feldes eine Höhe zwischen 1 µm und 10 mm, vorzugsweise zwischen 20 µm und 100 µm auf. Der Gasdruck in diesen Hohlräumen liegt zwischen 0,1 bar und 10 bar, d.h. zwischen 10⁴ Pa und 10⁶ Pa. Dieser im Vergleich zu anderen Gasentladungen recht hohe Gasdruck ist erforderlich damit in den mit obigen Abmessungen sehr kleinen Hohlräumen eine Gasentladung stabil betrieben werden kann. Um den apparativen Aufwand zur Einstellung des entsprechenden Gasdruckes (Pumpen etc. ) klein zu halten ist ein Gasdruck nahe Atmosphärendruck, d.h. zwischen 5*10⁴ Pa und 1,5*10⁵ Pa besonders vorteilhaft.

Der Hohlraum kann für den Austausch von Gasen oder Dämpfen offen sein, etwa indem er wenigstens teilweise durch eine netzartige oder durchgehend poröse Begrenzung abgeschlossen ist. Dies ist insbesondere dann wünschenswert, wenn bei einer Oberflächenmodifizierung, die mit einem nennenswerten Umsatz der angrenzenden Gasphase verbunden ist - etwa bei einer Beschichtung - , eine Zufuhr von Reaktanten und eine Abfuhr von Reaktionsprodukten erforderlich ist.

Es kann vorgesehen sein, dass unterschiedliche Hohlräume mit unterschiedlichen Gasen bzw. Gasgemischen beschickt werden. Auf diese Weise können Oberflächenbereiche unterschiedlich funktionalisiert werden. So ist es zum Beispiel möglich, dass einzelne Bereiche beschichtet, und andere Bereiche aktiviert werden.

Die sich in den Hohlräumen ausbildende Gasentladung ist eine Hohlraumteilentladung. Bei dieser handelt es sich um eine Gasentladung, die in Hohlräumen von Dielektrika auftreten, welche von elektrischen Feldern durchdrungen werden, vgl. E.H. R. Gaxiola und J.M. Wetzer, Conf. Record of the 1996 IEEE Inernational Symposium on Electrical Insulation, Montreal, Quebec, Canada, S. 420-423. Diese Hohlräume können entweder vollständig vom Dielelektrikum umgeben sein, oder sie können auch an eine metallische Elektrode angrenzen.

Hohlraumteilentladungen sind mit Barrierenentladungen, die seit Jahrzehnten für die Ozonsynthese, die Oberflächenbehandlung von Polymeren, und in Gasentladungslampen eingesetzt werden, insofern verwandt, als bei der Barrierenentladung auch mindestens ein Dielektrikum zwischen zwei Hochspannungselektroden vorliegt. Im Gegensatz zu Hohlraumteilentladungen handelt es sich jedoch immer um offene Anordnungen, d.h. es liegen keine geschlossenen Hohlräume vor.

Die Bereitstellung dieser Hohlräume, und damit die Ausnutzung der Hohlraumteilentladungen zu Zwecken der Oberflächenbehandlung, kann auf unterschiedliche Weise erfolgen. So ist es möglich, die Elektroden, vgl. **Fig. 2**, das Dielektrikum, vgl. **Fig. 1**, oder Elektroden und Dielektrikum mit einer geeigneten Oberflächenstruktur zu versehen. Je nach Oberflächenstruktur von Elektrode und angrenzendem Dielektrikum liegen dann zwischen ihnen Bereiche mit und ohne Formschluss vor. In den Bereichen ohne Formschluss liegen folglich Hohlräume vor, in denen sich die Hohlraumteilentladung ausbilden kann.

Die Strukturierung der einander angrenzenden Oberflächen von Elektrode und Dielektrikum mittels geeigneter Vertiefungen in denselben kann auf unterschiedliche Weisen erfolgen.

Befindet sich die Vertiefung an wohldefinierten Orten der jeweiligen Oberflächen, so kann eine ortselektive Oberflächenbehandlung in vorbestimmten Bereichen der Oberflächen vorgenommen werden.

Anstelle diesen Materialien eine geometrische definierte Topographie zu geben, und damit ortsselektiv zu behandeln, kann man die Elektrode, das Dielektrikum oder Dielektrikum und Elektrode statistisch strukturieren. Dies kann dadurch erfolgen, dass die Oberflächen stark aufgerauht werden, etwa durch eine Ätzprozess oder mechanisches Strahlen. In den dadurch gebildeten statistisch verteilten Vertiefungen bilden sich die Hohlräume, in denen sich bei genügend hohen Feldstärken Entladungen ausbilden, die zu einer räumlich statistischen Modifizierung der Oberfläche des Dielektrikums bzw. der Elektrode führen. Eine derartige statistische Strukturierung der Oberfläche soll im Sinne der vorliegenden Erfindung auch als eine Behandlung von vorgebbaren Oberflächenbereichen eines Körpers verstanden werden.

Die für die Ausbildung der Hohlraumteilentladungen erforderlichen Zündfeldstärken liegen i.a. im Bereich von 1 bis 5 kV/mm. Repetierende Entladungen werden bereits beim Anlegen von genügend hohen Gleichspannungen erzielt, welche typischerweise im Kilovoltbereich liegen. Da sich zwischen den Elektroden mindestens ein Dielektrikum befindet fließt kein galvanischer Strom sondern nur ein Verschiebungsstrom. Für den hier vorliegende Einsatz der Hohlraumteilentladung zur Oberflächenbehandlung ist es vorteilhaft, eine mittelfrequente Wechselspannung von 10 bis 50 kHz zu verwenden, da dann höhere mittlere Leistungen in die Entladung eingekoppelt werden können, so dass die gewünschten Effekte wesentlich rascher erzielt werden.

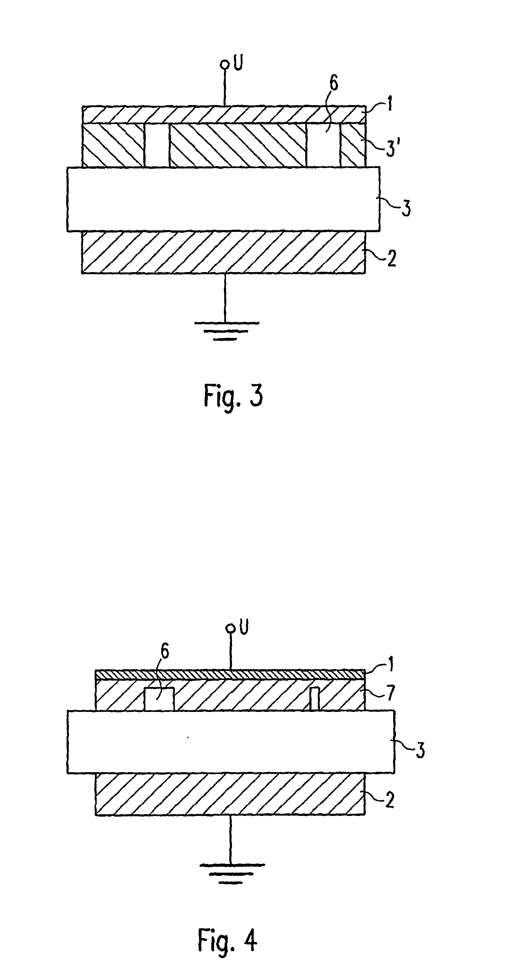

Um diejenigen Oberflächenbereiche, in denen kein Formschluss zwischen der oder den jeweiligen Elektroden und dem Dielektrikum vorliegt, bereitzustellen, kann auch ein zusätzlicher Isolator (Hilfsisolator) mit in diesen Bereichen befindlichen Vertiefungen. eingeführt werden. Besteht der Isolator aus dielektrischem Material so liegt demgemäß ein Hilfsdielektrikum vor. Dieses zusätzliche Dielektrikum kann grundsätzlich einen formschlüssigen Kontakt mit dem (Ausgangs-) Dielektrikum haben, aber zusätzliche Vertiefungen bzw. Aussparungen zur angrenzenden Elektrode hin besitzen. In diesem Fall wird nur die Elektrode oberflächenmodifiziert. Alternativ können die Aussparungen zum Dielektrikum gerichtet sein, wodurch es zu dessen Oberflächenbehandlung kommt. Handelt es sich um durchgehende Aussparungen, zum Beispiel weil das Hilfsdielektrikum gestanzt wurde, so können das Dielektrikum und die angrenzende Elektrode gleichzeitig behandelt werden. Letzteres zeigt **Fig. 3**, in der zwischen der Elektrode 1 und dem Dielektrikum 3 ein zusätzliches Hilfsdielektrikum 3' mit Aussparungen 6 gezeigt ist. In diesen Aussparungen 6 bildet sich die Gasentladung aus, was zur Behandlung der Oberfläche der metallischen Elektrode 1 und des Dielektrikums 3 führt.

Ein derartiges zusätzliches Dielektrikum kann eine mit Aussparungen versehene Platte oder Folie sein, wobei die Aussparungen in das Material eingestanzt werden können. Das Hilfsdielektrikum ist bevorzugt aus einem Elastomer, das sich an eventuell verhandenen Unebenheiten von Elektrode oder Dielektrikum gut anschmiegt.

Alternativ oder zusätzlich zum zusätzlichen Dielektrikum kann auch ein metallischer Körper für die Bereitstellung der Hohlräume eingesetzt werden, welcher zur angrenzenden Elektrode formschlüssigen Kontakt aufweist, und bei dem zum angrenzenden Dielektrikum die Hohlräume vorliegen. Dies zeigt **Fig. 4.** In dieser Figur befindet sich zwischen der Elektrode 1 und dem Dielektrikum 3 ein plattenförmiger metallischer Körper 7 mit Vertiefungen 6. Der plattenförmige metallische Körper 7 kann als eine metallische Hilfselektrode aufgefasst werden. Wie beim Fall des Hilfsdielektrikums können die Aussparungen zur Elektrode oder zum Dielektrikum hin ausgerichtet sein, oder es kann sich um durchgehende Aussparungen handeln. Weiterhin können Elektrode 1 und/oder die die Hilfselektrode 7 können gasdurchlässig ausgeführt sein.

Die Folien oder Platten, seien sie aus dielektrischen oder aus metallischen Material, können relativ zur Elektrode ortsfest oder auch beweglich angeordnet werden und lassen sich bei Verschmutzung oder Beschädigung leicht auswechseln.

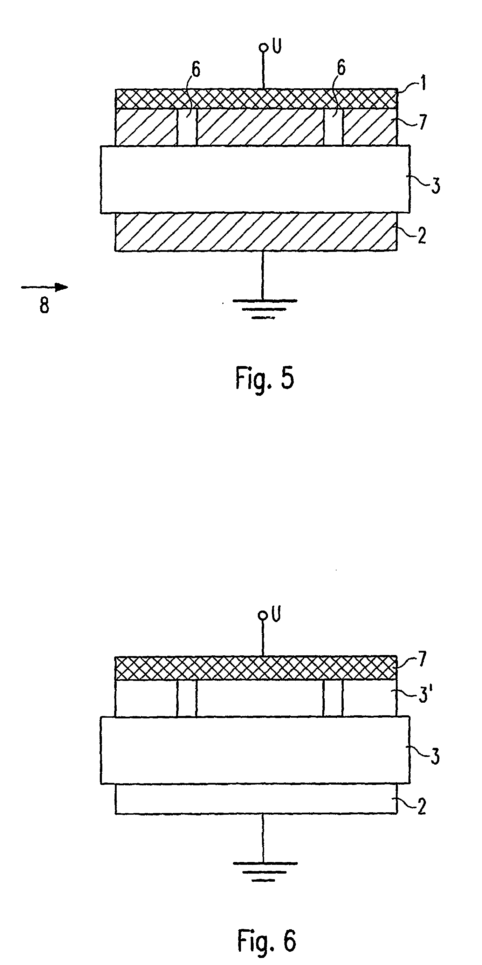

**Fig. 5** zeigt die weitere Möglichkeit auf, eine metallische Hilfselektrode 7 einzusetzen, welche sich zwischen der Elektrode 1 und dem Dielektrikum 3 befindet. Die Elektrode 1 ist gasdurchlässig ausgeführt, so dass ein Gasaustausch zwischen der Vertiefung 6 mit dem Außenraum 8 möglich ist. Die Elektrode 1 kann porös oder netzartig sein, zum Beispiel eine entsprechend geartete Folie oder Platte.

**Fig. 6** zeigt den Einsatz einer gasdurchlässigen Elektrode 7, welches an ein Hilfsdielektrikum 3' angrenzt.

Die beschriebenen Maßnahmen zur Bereitstellung der Hohlräume gewährleisten die sichere Vermeidung von Entladungen in den Bereichen mit Formschluss. Hierzu ist es besonders vorteilhaft, wenn das Dielektrikum bzw. das Hilfsdielektrikum aus einem Elastomer gefertigt wird, das sich eventuell vorhandenen Unebenheiten von Elektrode, Dielektrikum oder Hilfsdielektrikum gut anschmiegt. Auch durch eine geeignete ein- oder beidseitige Metallisierung der Folie oder Platte kann zur Unterdrückung der unerwünschten Entladungen beitragen.

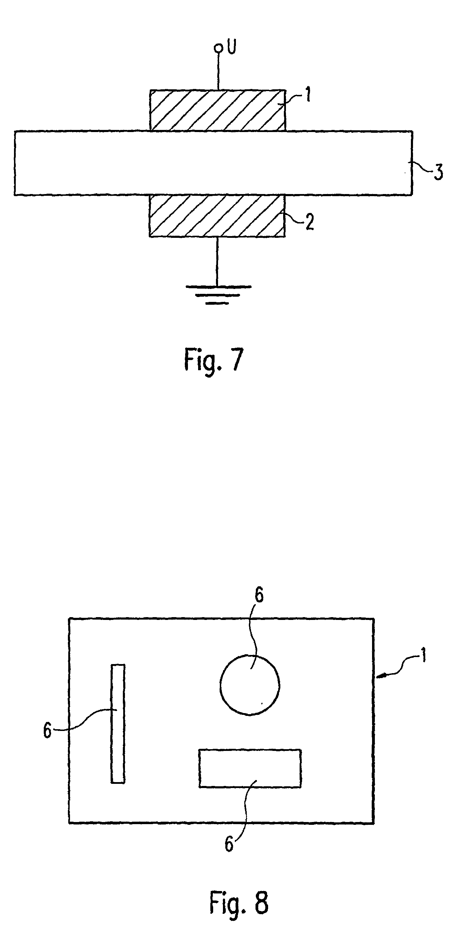

Eine weitere Möglichkeit zur Bereitstellung derjeniger Oberflächenbereiche, in denen kein Formschluss zwischen der jeweiligen Elektrode und dem Dielektrikum vorliegt, besteht darin, dass Aussparungen bereitgestellt werden, welche vollständig durch die Elektrode hindurchgehen. Dies wird durch **Fig. 7** und **Fig. 8** graphisch dargestellt. In der **Fig. 7** erkennt man in einer Seitenansicht ein Dielektrikum 3 zwischen zwei Elektroden 1 und 2. **Fig. 8** zeigt in einer Aufsicht die Anordnung von **Fig. 7**. Man erkennt Aussparungen 6, die rechteckig bzw. rund sind. Diese Aussparungen in den Elektroden gehen vollständig durch die Elektrode hindurch, d.h. das von oben innerhalb der Aussparungen 6 sichtbare Material ist das Material des Dielektrikums 3. Somit liegt im Bereich der Aussparungen kein Formschluss zwischen Dielektrikum 3 und Elektrode 1 vor, sehr wohl aber in den restlichen Bereichen. Beim Anlegen einer Spannung an die Elektroden kommt es auf der Oberfläche des Isolators innerhalb der Aussparung zur Ausbildung einer Oberflächengleitentladung. Diese modifiziert auf die gewünschte Art und Weise die Oberfläche des Dielektrikums.

Oberflächengleitentladungen, auch Oberflächenentladung genannt, breiten sich in der Gasphase entlang der Oberfläche eines Isolators aus. Auch bei dieser Entladungsform ist zwischen den beiden Elektroden eine Barriere erforderlich, in **Fig. 7** das Dielektrikum, um die Ausbildung einer thermischen Entladung zwischen den Elektroden 1, 2 und damit deren Kurzschluss zu verhindern. Die in der Entladung erzeugten Ladungsträger auf der Isolatoroberfläche werden beim Umpolen der angelegten Spannung wieder kompensiert und durch Ladungsträger mit dem entgegengesetzten Vorzeichen ersetzt.

Es handelt sich bei der Oberflächengleitentladung ebenso wie bei der Hohlraumteilentladung um eine kalte, transiente Gasentladung, deren Dauer mit typisch weniger als 100 Nanosekunden sehr kurz ist. Innerhalb dieser extrem kurzen Zeit kommt es zu keiner nennenswerten Erwärmung der Gasphase, weil sich auf dieser Zeitskala kein thermisches Gleichgewicht zwischen hochenergetischen Elektronen und den Gasatomen oder Molekülen einstellen kann. Im Gegensatz zu thermischen Entladungen, zum Beispiel Bogenentladungen, die Gastemperaturen von mehreren 1000 K erreichen, wird in Hohlraumteilentladungen und Oberflächengleitentladungen das Gas üblicherweise um weniger als 100 ° Celsius erwärmt, wenn bei längeren Betrieb der Entladung durch einen gewissen Mindestgasstrom oder andere Wärmeabfuhr dafür gesorgt ist, dass es nicht zu einer Akkumulation thermischer Energie kommt.

Beim Einbringen des Dielektrikums und ggf. des Hilfdielektrikums bzw. der Hilfselektrode in Form eines metallischen Körpers unter atmosphärischen Bedingungen wird in den Hohlräumen bzw. Aussparungen stets ein Gas vorhanden sein, welches die Ausbildung einer Gasentladung bei Anliegen einer Spannung an die Elektroden ermöglicht. Die Behandlung der entsprechenden Oberflächenbereiche erfolgt bei einem Gasdruck zwischen 0,1 bar und 10 bar, d.h. zwischen 10⁴ Pa und 10⁶ Pa, vorzugsweise zwischen 0,5 bar und 1,5 bar, d.h. zwischen 5*10⁴ Pa und 1,5*10⁵ Pa.

Es kann ein oxidierendes Gas oder Gasgemisch wie Sauerstoff, Luft, oder ein anderes sauerstoffhaltiges Gas in den Hohlräumen bzw. den Aussparungen vorliegen. Wird kein oxidierendes Gas oder Gasgemisch gewünscht, so bieten sich insbesondere Stickstoff, Argon oder andere Edelgase an.

Wird eine Schichtabscheidung in den relevanten Oberflächenpartien gewünscht, so werden Kohlenwasserstoffverbindungen, Fluorkohlenwasserstoffe, Fluorkohlenstoffe, polymerisationsfähige Monomere, oder siliciumorganische Verbindungen gewählt, und zwar rein oder in Verdünnung mit einem Edelgas oder einem oxidierenden Gas.

Wird keine Schichtabscheidung in den relevanten Oberflächenpartien gewünscht, so erlaubt das erfindungsgemäße Verfahren bei polymeren Dielektrika die Bildung lokalreaktiver Zentren auf den Oberfläche, die bei einem nachfolgenden Kontakt mit einer geeigneten gelösten oder gasförmigen Substanz eine chemische Reaktion eingehen, die zur Ausbildung einer chemischen Bildung führen.

Die an die Elektroden angelegte Spannung ist bevorzugt eine Wechselspannung mit einer Frequenz zwischen 50 Hz und 1000 kHz, vorzugsweise zwischen 10 kHz und 100 kHz. Die gewählte Spannung ist davon abhängig, welchen Abstand die Elektroden haben, und welche dielektrische Konstante das dazwischen befindliche Material aufweist. Die Spannung muss so gewählt werden, dass in den Hohlräumen elektrische Feldstärken im Bereich von 1 bis 5 kV/mm erreicht werden. Es spielt dabei für die Oberflächenmodifizierung keine Rolle, ob die strukturierte Elektrode eine geerdete Elektrode oder eine Hochspannungselektrode darstellt. Alternativ zum Einsatz von Wechselspannungen können auch unipolare Spannungspulse an die Elektroden angelegt werden.

Das erfindungsgemäße Verfahren erlaubt eine Vielzahl von Behandlungsmöglichkeiten von Materialien.

Das erfindungsgemäße Verfahren erlaubt sowohl eine örtlich wohldefinierte, als auch eine statistisch verteilte Strukturierung von Polymeroberflächen in oxidierender Atmosphäre. Durch diese Behandlung können die relevanten Oberflächenpartien lokal benetzbar gemacht werden, d.h. die dortige Oberflächenspannung wird gesteigert bzw. dort polare Gruppen erzeugt. An den exponierten Stellen kann anschließend ein Bekeimungsprozess für eine nasschemische und zunächst stromlose Metallisierung stattfinden, da die Edelmetallionen wie z.B. Palladiumionen sich hier besonders fest anlagern. Das qualitativ gleiche Ergebnis wird durch eine Behandlung in einer Inertgasentladung erzielt, wenn die Polymeroberfläche anschließend der Luft ausgesetzt wird, da dann die erzeugten und sehr reaktiven Zentren an der Oberfläche mit Sauerstoff zu polaren Gruppen reagieren.

Das erfindungsgemäße Verfahren erlaubt es ferner, vorbestimmte Oberflächenbereiche mit vorbestimmten chemisch funktionellen Gruppen auszustatten. Dies lässt sich dadurch realisieren, dass die Behandlung in geeigneten polymerisationsfähigen Gasen stattfindet, und der eigentliche Pfropf-Polymerisationsprozess auf der Polymeroberfläche durch die Entladung ausgelöst wird. Geeignete Gase sind Allylalkohol, Allylamin, Propargylalkohol und Propargylamin, Acrylsäure oder Metacrylsäure oder ihre Derivate oder andere Verbindungen mit polymerisationsfähigen Doppel- oder Dreifachbindungen zwischen Kohlenstoffatomen. Die dadurch bereitgestellten chemisch-funktionellen Gruppen an den aufgepfropften Ketten stellen festen Ankerpunkte für mögliche weitere Beschichtungen oder Anlagerungen dar. Neben technischen Anwendungen wie zum Beispiel die strukturierte Metallisierung im Additivverfahren ist diese selektive Plasma-Pfropfung besonders für biologisch-medizinische Anwendungen von hohem Interesse, weil die Adhäsion biologischer Materialien wie Zellen und Proteine durch bestimmte funktionelle Gruppen gezielt gefördert oder behindert werden kann.

Das erfindungsgemäße Verfahren erlaubt es ferner, durch einen Sputterprozess geringe Mengen des Metalls der Elektrode auf das Polymer zu übertragen. Ein Sputterprozess über die Gasentladung ist an sich wegen der relativ geringen Energie für die verfügbaren Ionen und des hohen Druckes sehr ineffektiv. Die aus der metallischen Elektrode herausgeschlagenen Atome thermalisieren auf einer Strecke von wenigen Mikrometern und diffundieren dann zum Dielektikum bzw. dem Polymer. Die auf diese Weise abgetragenen Mengen sind jedoch hinreichend um als Keime für eine Metallisierung zu dienen.

Werden Hohlräume bereitgestellt und Hohlraumteilentladungen gezündet, so lassen sich beim Vorhandenensein geeigneter polymerisationsfähiger Gase in den Hohlräumen Plasmapolymerschichten abscheiden, oder aber vorhandene dünne Polymerfilme oder etwa auch Ölfilme strukturiert abtragen. Die Plasmapolymerisation kann entweder aus dem im Hohlraum eingeschlossenen Gasvolumen erfolgen, es kann aber auch vorgesehen sein, dass über kleine Zuführungskanäle polymerisationsfähige Gase in die Hohlräume eingebracht werden. Im letztgenannten Fall erlaubt dies die Abscheidung größerer Mengen von Plasmapolymeren. Als Alternative können auch feinmaschige Netze eingesetzt werden, die für die entsprechenden Gase durchlässig sind, elektrisch aber als Elektrode wirken. Wenn die Hohlräume wenigstens partiell durch netzartige oder durchgehend poröse Begrenzungen ausgebildet sind, sind sie für Gase zugängig, beuüglich des elektrischen Feldes verhalten sie sich wie vollständig abgeschlossene Hohlräume.

Eine weitere Anwendung des erfindungsgemäßen Verfahrens besteht in der Ausnützung der Redeposition von Polymermaterial, welches vom Dielektrikum abgetragen wird, und sich partiell auf der Metalloberfläche abscheidet. Derartige Effekte werden zum Beispiel bei der Verwendung von PTFE-Dielektrika beobachtet und führen an exponierten Stellen des Metalls zu einer Hydrophobisierung.

Obwohl in der bisherigen Darstellung der Erfindung und auch in den Abbildungen Planarelektroden und planare Dielektrika dargestellt wurden, kann das beschriebene Verfahren auch auf diejenigen Fälle angewendet werden, in denen die zugrundeliegende Elektrodenanordnung nicht eben ist, sondern eine beliebige dreidimensionale Geometrie aufweist. So können insbesondere auch dreidimensionale Schaltungsträger mit Hilfe der daran angepassten Elektroden strukturiert behandelt und dann beispielsweise nasschemisch metallisiert werden. Auch eine Anordnung mit einer zylindrisch geformten Elektrode und einer daran angepassten Gegenelektrode in Form eines Teilzylinders ist möglich, um zum Beispiel Polymerfolien als Bänder behandeln. Durch eine geeignete Wahl der Prozessgase kann bewirkt werden, dass die Entladung nur in den Hohlräumen brennt und damit nur auf einer Seite der Polymerfolien. Dies kann dadurch gewährleistet werden, dass auf der nicht zu behandelnden Rückseite der Polymerfolie Luft oder ein anderes schwerionisierbares Gas bereitgestellt wird.

Nachfolgend soll das erfindungsgemäße Verfahren anhand von Ausführungsbeispielen näher erläutert werden.

### Ausführungsbeispiel 1:

Aus einer Metallplatte A aus Edelstahl wird ein Rezess mit 50 µm Tiefe und einem Durchmesser von 10 mm herausgefräst. Diese Metallplatte A wird auf eine 50 µm dicke BOPP-Folie gepresst, die auf einer ebenen geerdeten Metallplatte B liegt. Durch Anlegen einer Wechselspannung von 750 V und einer Frequenz von 40 kHz wird in dem umschlossenen Gasvolumen eine Hohlraumteilentladung gezündet. Nach einer Behandlungszeit von 10 s wird auf dem behandelten Flächenstück ein Randwinkel mit Wasser von 46° gemessen. Der Referenzwert in unmittelbarer Nähe zur behandelten Fläche, d.h. im Bereich, in dem Formschluss vorlag, liegt bei 88° und entspricht damit dem Wert einer unbehandelten Folie.

### Ausführungsbeispiel 2:

Eine entsprechend Ausführungsbeispiel 1 behandelte BOPP-Folie wird in einem bekannten naßchemischen Verfahren metallisiert: Bekeimung mit Palladium, Reduktion, stromlose Metallisierung mit 100 nm Nickel, galvanische Verstärkung mit 10 um Kupfer. Die Metallisierung findet ausschließlich an dem behandelten Flächenstück der BOPP-Folie statt, d.h. an denjenigen Oberflächenbereichen, an denen kein Formschluss vorlag. Der Durchmesser der metallisierten Fläche beträgt 10 mm, die Ränder sind glatt strukturiert. Die Metallisierung ist haftfest im Abzugversuch mit einem Klebeband (Tesa-Test).

### Ausführungsbespiel 3:

Aus einer 2 mm dicken Platte aus PTFE (Breite x Länge = 100 mm x 100 mm) wird ein streifenförmiger Rezess mit 100 µm Tiefe, 10 mm Breite und 50 mm Länge herausgefräst. Diese so strukturierte PTFE-Platte wird unter Stickstoffatmosphäre in zwei Metallplatten fest eingespannt. Die an die strukturierte Seite der PTFE-Platte angrenzenden Metallplatte A wird auf Massepotential gelegt. Durch Anlegen einer mittelfrequenten Spannung von 2000 V und einer Frequenz von 46 kHz an die andere Metallplatte B bildet sich eine Hohlraumteilentladung im eingeschlossenen Gasvolumen aus. Nach einer Behandlungszeit von 1 Minute wird die Metallplatte A auf der behandelten Seite mit einem ganzflächigen Wasserfilm versehen. Der Wasserfilm entnetzt spontan an dem streifenförmigen Bereich, der in der Hohlraumteilentladung behandelt wurde. Folglich wurde der behandelte Bereich der Metallplatte A durch die Hohlraumteilentladung hydrophobisiert. Anhand einer Messung mittels Sekundärionen-Massenspektrometrie (SIMS) wird an den behandelten Bereichen der Metallplatte A ein im Vergleich mit unbehandelten Bereichen erhöhter Fluorgehalt in den obersten 2 - 5 nm bestimmt.

### Ausführungsbeispiel 4:

In einer Anordnung entsprechend Ausführungsbeispiel 3 wird in die den Hohlraum ausfüllende Stickstoffatmosphäre zusätzlich die siliciumorganische Verbindung Hexamethyldisiloxan (HMDSO) mit einer Konzentration von 5 vol% eingebracht. Nach einer Behandlungszeit von 30 s lässt sich mit SIMS eine 5 nm dicke Schicht bestehend aus 12 at% Silicium, 31 at% Kohlenstoff, 7 at% Stickstoff, 12 at% Sauerstoff und 38 at% Wasserstoff nachweisen. Diese Schicht ist durch eine leichte Verfärbung optisch auf der Metallplatte A zu erkennen. Die Umrandung der beschichteten Fläche ist scharf von dem unbeschichteten Bereich der Metallplatte A abgegrenzt. Die Maße des beschichteten Flächenbereiches entsprechen exakt dem Rezess in der PTFE-Platte.

### Ausführungsbeispiel 5:

Auf einer Hochspannungslektrode befindet sich eine 0,3 mm dicke Glasplatte von 10 cm Durchmesser. Darauf ist eine geerdete Elektrode aufgesetzt, welche mit einer Aussparung in Form eines gleichschenkligen Dreiecks versehen ist. Das Dreieck hat eine Schenkellänge von 1 cm und einer Basis von 0,1 mm

Die Anordnung befindet sich in einer Atmosphäre aus Tetraethylorthosilikat (TEOS) in Stickstoff. Der Gesamtgasdruck beträgt 95 kPa, und der TEOS-Partialdruck 200 Pa. An die Elektroden wird eine Spannung von 2000 V bei einer Frequenz von 35 kHz angelegt. Nach 2 min liegt eine Schicht von 230 nm Dicke in Form des o.g. Dreiecks vor.

## Patentansprüche

1. Verfahren zur plasmagestützten Behandlung von vorgebbaren Oberflächenbereichen eines Körpers (1, 2, 3),
bei der durch Anlegen einer Spannung an zwei Elektroden (1, 2) eine kalte, transiente Gasentladung bei Gasdrücken zwischen 10⁴ Pa und 10⁶ Pa betrieben wird,
und bei dem zwischen den Elektroden (1, 2) ein elektrischer Isolator (3) derart eingebracht wird
- dass in den vorgegebenen Oberflächenbereichen (5) kein formschlüssiger Kontakt zwischen dem Isolator (3) und der jeweiligen Elektrode vorliegt,
- und dass in den restlichen Oberflächenbereichen (4) der Isolator (3) und die jeweilige Elektrode in formschlüssigem Kontakt stehen,
**dadurch gekennzeichnet,**
**dass** der Isolator derart eingebracht wird, dass in den Bereichen (5) ohne Formschluss gasgefüllte Hohlräume vorliegen in denen sich die Gasentladung ausbildet sodass ausschließlich die Hohlrauminnenwände oberflächenbehandelt werden.

2. Verfahren nach Anspruch 1, **dadurch gekennzeichnet, dass** als Oberflächenbereiche (5) ohne Formschluss Vertiefungen (6) in Elektrode und/oder Isolator (3) vorgesehen sind.

3. Verfahren nach Anspruch 1 oder 2, **dadurch gekennzeichnet, dass** die Oberflächenbereiche (5) ohne Formschluss durch Einfügen eines zusätzlichen, in diesen Bereichen mit Vertiefungen versehenen Hilfsisolators (3') zwischen Isolator (3) und Elektrode (1, 2) bereitgestellt werden.

4. Verfahren nach mindestens einem der Ansprüche 1 bis 3, **dadurch gekennzeichnet, dass** die Oberflächenbereiche (5) ohne Formschluss durch Einfügen einer zusätzlichen, in diesen Bereichen mit Vertiefungen versehenen Hilfselektrode (7) zwischen Isolator 3 und Elektrode (1, 2) bereitgestellt werden.

5. Verfahren nach mindestens einem der Ansprüche 1 bis 2, **dadurch gekennzeichnet, dass** als Oberflächenbereiche (5) ohne Formschluss Aussparungen (6) vorgesehen sind, welche vollständig durch die Elektrode (1 oder 2) hindurchgehen.

6. Verfahren nach mindestens einem der Ansprüche 1 bis 5, **dadurch gekennzeichnet, dass** als Isolator (3) ein Dielektrikum vorgesehen ist.

7. Vorrichtung zur plasmagestützten Behandlung von vorgebbaren Bereichen einer Oberfläche, umfassend eine Elektrodenanordnung mit zwei Elektroden (1, 2) und einem dazwischen befindlichen elektrischen Isolator (3), wobei zwischen Elektrode (1, 2) und Isolator (3) Bereiche mit und ohne Formschluss vorgesehen sind,
**dadurch gekennzeichnet,**
**dass** in den Bereichen ohne Formschluss Hohlräume vorliegen in deren Inneren eine Hohlraumteilentladung zur Behandlung der Hohlrauminnenwand betreibbar ist

8. Vorrichtung nach Anspruch 7, **dadurch gekennzeichnet, dass** zwischen Elektrode (1, 2) und Isolator (3) ein mit Vertiefungen versehener Hilfsisolator (3') vorgesehen ist.

9. Vorrichtung nach Anspruch 7 oder 8, **dadurch gekennzeichnet, dass** zwischen Elektrode (1, 2) und Isolator (3) eine mit Vertiefungen versehene Hilfselektrode (7) vorgesehen ist.

10. Vorrichtung nach mindestens einem der Ansprüche 7 bis 9, **dadurch gekennzeichnet, dass** eine Elektrode (1, 2) oder die Hilfselektrode (7) gasdurchlässig ausgeführt ist.

11. Vorrichtung nach mindestens einem der Ansprüche 7 bis 10, **dadurch gekennzeichnet, dass** eine Elektrode mit vollständig durchgehenden Aussparungen (6) vorgesehen ist.

12. Vorrichtung nach mindestens einem der Ansprüche 7 bis 11, **dadurch gekennzeichnet, dass** als elektrischer Isolator (3) ein Dielektrikum vorgesehen ist.

13. Verwendung des Verfahrens nach mindestens einem der Ansprüche 1 bis 6 zur plasmagestützten Behandlung der Oberfläche der Elektrode (1, 2) und/oder des Isolators (3).

14. Verwendung des Verfahrens nach mindestens einem der Ansprüche 1 bis 5 zur Schichtabscheidung, zur Bekeimung des Isolators (3) mit Elektrodenmaterial, zur Veränderung der Oberflächenspannung von Elektrode (1, 2) und/oder Isolator (3)

## Claims

1. Process for the plasma-enhanced treatment of predeterminable surface regions of a body (1, 2, 3),
in which a cold, transient gas discharge is operated at gas pressures between 10⁴ Pa and 10⁶ Pa by a voltage being applied to two electrodes (1, 2),
and in which an electrical insulator (3) is introduced between the electrodes (1, 2), in such a manner
- that there is no form-fitting contact between the insulator (3) and the respective electrode in the predetermined surface regions (5),
- and that in the remaining regions (4) the insulator (3) and the respective electrode are in form-fitting contact,
**characterized**
**in that** the insulator is introduced in such a manner that in the regions (5) without a form fit there are gas-filled cavities in which the gas discharge forms, so that only the cavity inner walls are surface-treated.

2. Process according to Claim 1, **characterized in that** recesses (6) in electrode and/or insulator (3) are provided as surface regions (5) without a form fit.

3. Process according to Claim 1 or 2, **characterized in that** the surface regions (5) without a form fit are provided by insertion of an additional auxiliary insulator (3'), which is provided with recesses in these regions, between insulator (3) and electrode (1, 2).

4. Process according to at least one of Claims 1 to 3, **characterized in that** the surface regions (5) without a form fit are provided by insertion of an additional auxiliary electrode (7), which is provided with recesses in these regions, between insulator 3 and electrode (1, 2).

5. Process according to at least one of Claims 1 to 2, **characterized in that** cutouts (6) which run all the way through the electrode (1 or 2) are provided as surface regions (5) without a form fit.

6. Process according to at least one of Claims 1 to 5, **characterized in that** the insulator (3) provided is a dielectric.

7. Device for the plasma-enhanced treatment of predeterminable regions of a surface, comprising an electrode arrangement having two electrodes (1, 2) and an electrical insulator (3) located between the electrodes, regions with or without a form fit are provided between electrode (1, 2) and insulator (3),
**characterized**
**in that** in the regions without a form fit there are cavities, in the interior of which a cavity partial discharge can be operated in order to treat the cavity inner wall.

8. Device according to Claim 7, **characterized in that** an auxiliary insulator (3') provided with recesses is provided between electrode (1, 2) and insulator (3).

9. Device according to Claim 7 or 8, **characterized in that** an auxiliary electrode (7) provided with recesses is provided between electrode (1, 2) and insulator (3).

10. Device according to at least one of Claims 7 to 9, **characterized in that** an electrode (1, 2) or the auxiliary electrode (7) is of gas-pervious design.

11. Device according to at least one of Claims 7 to 10, **characterized in that** an electrode with cutouts (6) which run all the way through it is provided.

12. Device according to at least one of Claims 7 to 11, **characterized in that** the electrical insulator (3) provided is a dielectric.

13. Use of the process according to at least one of Claims 1 to 6 for the plasma-enhanced treatment of the surface of the electrode (1, 2) and/or the insulator (3).

14. Use of the process according to at least one of Claims 1 to 5 for layer deposition, for seeding of the insulator (3) with electrode material, for changing the surface tension of electrode (1, 2) and/or insulator (3).

## Revendications

1. Procédé de traitement par plasma de zones de surface préalablement définies d'un corps (1, 2, 3),
au cours duquel, si on applique une tension aux deux électrodes (1, 2), il y a une décharge de gaz froide et transitoire pour des pressions gazeuses comprises entre 10⁴ Pa et 10⁶ Pa.,
et au cours duquel un isolant électrique (3) est placé entre les électrodes (1, 2) de telle façon que
- dans les zones de surface préalablement définies (5), il n'y a aucun contact à engagement positif entre l'isolant (3) et chaque électrode
- et dans le reste des zones de surface (4), l'isolant (3) et chaque électrode possèdent un contact à engagement positif,
**caractérisé en ce que**
l'isolant est inséré de telle façon qu'il y a, dans les zones (5) sans engament positif, des espaces vides remplis de gaz dans lesquels une décharge de gaz a lieu pour que les parois internes de ces espaces vides soient exclusivement traitées en surface.

2. Procédé selon la revendication 1,
**caractérisé en ce que**
des cavités (6) sont prévues dans l'électrode et/ou l'isolant (3) comme zones de surface (5) sans engament positif.

3. Procédé selon la revendication 1 ou 2,
**caractérisé en ce que**
les zones de surface (5) sans engagement positif sont préparées en insérant entre l'isolant (3) et l'électrode (1, 2) un isolant auxiliaire (3') supplémentaire, équipé de cavités dans ces zones.

4. Procédé selon au moins l'une des revendications 1 à 3,
**caractérisé en ce que**
les zones de surface (5) sans engament positif sont préparées en insérant entre l'isolant (3) et l'électrode (1, 2) une électrode auxiliaire (7) supplémentaire, équipée de cavités dans ces zones.

5. Procédé selon au moins l'une des revendications 1 à 2,
**caractérisé en ce que**
des évidements (6) sont prévus pour servir de zones de surface (5) sans engagement positif, ces évidements traversant entièrement l'électrode (1 ou 2).

6. Procédé selon au moins l'une des revendications 1 à 5,
**caractérisé en ce qu'**
un diélectrique est prévu pour servir d'isolant (3).

7. Dispositif de traitement par plasma des zones préalablement définies d'une surface comprenant un dispositif de deux électrodes (1, 2) et un isolant électrique (3) situé entre les deux, des zones avec et sans engament positif étant prévues entre l'électrode (1, 2) et l'isolant,
**caractérisé en ce que**
dans les zones sans engagement positif, on trouve des espaces vides à l'intérieur desquels une décharge d'une partie de l'espace vide peut être utilisée pour traiter la paroi interne de l'espace vide.

8. Dispositif selon la revendication 7,
**caractérisé en ce qu'**
un isolant auxiliaire (3'), équipé de cavités, est prévu entre l'électrode (1, 2) et l'isolant (3).

9. Dispositif selon la revendication 7 ou 8,
**caractérisé en ce qu'**
une électrode auxiliaire (7), équipée de cavités, est prévue entre l'électrode (1, 2) et l'isolant (3).

10. Dispositif selon au moins l'une des revendications 7 à 9,
**caractérisé en ce qu'**
une électrode (1, 2) ou l'électrode auxiliaire (7) sont perméables au gaz.

11. Dispositif selon au moins l'une des revendications 7 à 10,
**caractérisé en ce qu'**
une électrode comprend des évidements (6) la traversant entièrement.

12. Dispositif selon au moins l'une des revendications 7 à 11,
**caractérisé en ce qu'**
un diélectrique est prévu pour servir d'isolant électrique (3).

13. Utilisation du procédé selon au moins l'une des revendications 1 à 6, pour le traitement par plasma de la surface de l'électrode (1, 2) et/ou de l'isolant (3).

14. Utilisation du procédé selon au moins l'une des revendications 1 à 5, pour la séparation des couches, pour la germination de l'isolant (3) avec le matériau des électrodes, pour le changement de la tension de surface de l'électrode (1, 2) et/ou de l'isolant (3).
